**Europäisches Patentamt**

**European Patent Office**

**Office européen des brevets**

(19)

(11) Veröffentlichungsnummer: **0 214 461 B1**

(12) **EUROPÄISCHE PATENTSCHRIFT**

(45) Veröffentlichungstag der Patentschrift: **10.04.91**

(51) Int. Cl.⁵: **B26F 3/00**, H05K 3/00

(21) Anmeldenummer: **86110722.5**

(22) Anmeldetag: **02.08.86**

(54) **Vorrichtung zum Abziehen der Schutzfolie von einer mit belichtetem Fotoresist beschichteten Leiterplatte.**

(30) Priorität: **12.09.85 DE 3532553**

(43) Veröffentlichungstag der Anmeldung:
**18.03.87 Patentblatt 87/12**

(45) Bekanntmachung des Hinweises auf die
Patenterteilung:
**10.04.91 Patentblatt 91/15**

(84) Benannte Vertragsstaaten:
**AT BE CH FR GB IT LI LU NL SE**

(56) Entgegenhaltungen:
**DE-A- 3 339 723        DE-B- 1 779 125**
**US-A- 3 451 872        US-A- 3 929 555**
**US-A- 3 996 127        US-A- 4 183 751**

**PATENT ABSTRACTS OF JAPAN, Band 9, Nr.
6 (P-326)[1729], 11. Januar 1985; & JP-A-59
154 446 (HITACHI KASEI KOGYO K.K.)
03-09-1984**

**PATENT ABSTRACTS OF JAPAN, Band 9, Nr.
6 (P-326)[1729], 11. Januar 1985; & JP-A-59
154 447 (HITACHI KASEI KOGYO K.K.)
03-09-1984**

**PATENT ABSTRACTS OF JAPAN, Band 9, Nr.**

**198 (M-404)[1921], 15. August 1985; & JP-A-60
61 458 (MATSUSHITA DENKO K.K.)
09-04-1985**

(73) Patentinhaber: **Löhr & Herrmann GmbH
Hesselbachstrasse 15
W-7531 Neuhausen(DE)**

(72) Erfinder: **Herrmann, Gunter, Dr.-Ing.
Hindenburgstrasse 21
W-7260 Calw(DE)**
Erfinder: **Löhr, Hans-Günter, Dr.-Ing.
Ahornweg 3
W-7135 Wiernsheim(DE)**
Erfinder: **Mozzi, Josef
Landhausstrasse 20
W-7267 Unterreichenbach(DE)**

(74) Vertreter: **Hubbuch, Helmut, Dipl.-Ing et al
Patentanwälte Dr. Rudolf Bauer Dipl.-Ing.
Helmut Hubbuch Dipl.-Phys. Ulrich Twelmeier Westliche Karl-Friedrich-Strasse 29-31
W-7530 Pforzheim(DE)**

**Beschreibung**

Die Erfindung bezieht sich auf eine Vorrichtung zum Abziehen der Schutzfolie von einer mit belichtetem Fotoresist beschichteten Leiterplatte.

Es ist bekannt, die Schutzfolien von Hand abzuziehen, indem man mittels eines Messers die Schutzfolie an einer Ecke von der darunterliegenden Fortoresistschicht ablöst, den Zipfel erfaßt und die Schutzfolie dann abzieht. Das führt jedoch leicht zu Beschädigungen der Fotoresistschicht durch die Schneide und damit zum Einreißen oder Einschneiden der kerbempfindlichen Schutzfolie, wodurch diese beim Abziehen überdies abreissen kann.

Auch ist nach der DE-A-33 39 723 eine Vorrichtung bekannt, bei welcher das Ablösen und Abziehen der Schutzfolie dadurch erfolgt, daß man Klebstreifen aufbringt, und sie mit Hilfe derselben in diagonaler Richtung abzieht. Das Aufbringen der Klebestreifen und das Abziehen der Schutzfolie erfolgt bei der bekannten Vorrichtung im Durchlauf, während die Leiterplatten auf einem Waagerechtförderer liegen, welcher durch ein angetriebenes Rollenfeld gebildet wird. Die bekannte Vorrichtung hat den Nachteil, daß sich die Klebebänder während des Abziehvorganges gelegentlich von der Schutzfolie lösen, wodurch es zu Störungen im Arbeitsablauf kommt, die in einer weitgehend automatisierten Fertigungslinie nicht tragbar sind.

Desweiteren ist es nach der DE-A-27 47 265 bekannt, die Schutzfolie bei auf einem Trägermaterial auflaminiertem Photopolymer vermittels aufwalzbarem Klebeband abzuziehen, was jedoch mangels Zuverlässigkeit auch leicht zu Störungen bei kontinuierlichem Durchlauf führen kann.

Schließlich ist nach der US-PS 4 183 751 eine Vorrichtung zum Abziehen der Schutzfolie von einer mit belichtetem Fotoresist beschichteten Leiterplatte und einem dieselbe in den Bereich einer Abziehvorrichtung transportierenden Förderer bekannt, welcher die Laufebene der Leiterplatte definiert und wenigstens einem Klemmbackenpaar, welches in Abziehrichtung beweg- und schließbar ist, wobei die beiden Backen je eine quer zur Abziehrichtung parallel zur Laufebene verlaufende, den Klemmspalt zwischen den Backen begrenzenden Kante zum Anlegen an die jeweilige Leiterplatte haben, wobei sich auch die vorgeschilderten Nachteile ergeben können.

Der Erfindung liegt nun die Aufgabe zugrunde, eine Vorrichtung zum Abziehen der Schutzfolie von der Fotoresistschicht einer Leiterplatte zu schaffen, mit welcher sich die Schutzfolie ohne Beschädigung der Fotoresistschicht zunächst an einer Ecke lösen und dann sicher abziehen läßt, wobei sich diese Vorrich tung insbesondere für eine Automatisierung eignet.

Diese Aufgabe wird gelöst durch eine Vorrichtung mit den im Anspruch 1 angegebenen Merkmalen. Vorteilhafte Weiterbildungen der Erfindung sind Gegenstand der Unteransprüche.

Erfindungsgemäß wird ein Zipfel des aus der Fotoresistschicht und der Schutzfolie gebildeten Laminats von der Leiterplatte abgeschält, und diesen Zipfel ergreift man, um die Schutzfolie abzuziehen. Damit dennoch nur die Schutzfolie, nicht aber größere Teile der Fotoresistschicht von der Leiterplatte abgezogen werden, wird die Fotoresistschicht vor dem Abschälen des Zipfels gequetscht; das hat zur Folge, daß die Fotoresistschicht an der gequetschten Stelle abreißt, sobald man an dem abgeschälten Zipfel zu ziehen beginnt, sodaß nur die Schutzfolie abgezogen wird. Die Tatsache, daß ein kleiner Zipfel der Fotoresistschicht mit abgeschält wird, ist unschädlich, da ein Randstreifen an der Fotoresistschicht für die fotografische Belichtung dieser Schicht nicht benötigt wird.

Durch das Abquetschen der Fotoresistschicht längs eines schmalen Streifens ist sichergestellt, daß die Fotoresistschicht genau an dieser Stelle abreißt und eine Beschädigung des jenseits dieses Streifens gelegenen Hauptteils der Fotoresistschicht unterbleibt.

Ein zumindestens weitgehend automatisches Abschälen eines Zipfels des aus der Schutzfolie und der Fotoresistschicht gebildeten Laminats gefolgt von dem Abziehen der Schutzfolie ist mittels eines Klemmbackenpaares möglich, wie dies der Patentanspruch 1 beschreibt. In der erfindungsgemäßen Vorrichtung wird die Leiterplatte, von welcher die Schutzfolie abgezogen werden soll, auf dem Förderer in den Bereich des Klemmbacken paares gefördert, in Bezug auf das Klemmbackenpaar positioniert. Die Positionierung erfolgt in der Weise, daß von den beiden Klemmbacken, welche auf die Leiterplatte aufgesetzt werden, der eine Backen mit seiner den Klemmspalt begrenzenden Kante auf der Schutzfolie steht und dabei sich vom einen zum anderen der beiden in der abzulösenden Ecke zusammentreffenden Schutzfolienränder erstreckt, wobei er gegen die Leiterplatte drückt und dabei den darunter liegenden Bereich der Fotoresistschicht quetscht. Ein geeigneter Abstand dieses einen Backen von der Ecke der Schutzfolie ist ungefähr 1 Zentimeter. Der andere Backen liegt dem auf der Schutzfolie stehenden Backen parallel gegenüber und liegt außerhalb der Schutzfolie der Leiterplatte auf. Zum Abschälen wird der außerhalb der Schutzfolie auf die Leiterplatte aufgesetzte Backen gegen den anderen Backen bewegt, welcher in Ruhe bleibt. Dabei wird ein Zipfel des aus der Schutzfolie und der Fotoresistschicht gebildeten Laminats von der Leiterplatte abgeschält und zwischen den beiden Klemmbacken eingeklemmt. Um diese Aufgabe durchführen zu können, ist der die Schließbewegung vollführende Backen geringfügig nämlich ungefähr um die Dicke der Schutzfolie näher bei der Laufebene der Leiterplatten angeordnet; dadurch wird erreicht, das dann, wenn dieser Backen der Leiterplatte aufliegt, der andere Backen die Fotoresistschicht hinreichend gequetscht, die Schutzfolie jedoch nicht beschädigt hat. Die Quetschung kann entlang einer Linie geschehen; da die Schutzfolien überlicher Weise jedoch kerbempfindlich sind, quetscht man die Fotoresistschicht zweckmäßiger weise mittels eines schmalen Streifens, wodurch die Gefahr die Schutzfolie zu kerben, ausgeschlossen werden kann. Das Quetschen längs eines solchen schmalen Streifens geschieht zweckmäßigerweise mittels eines schmalen, zur Laufebene parallelen Oberflächenbereiches des Backens angrenzend an dessen den Klemmspalt begrenzende Kante; anschließend an diesen schmalen Streifen sollte die der Laufebene gegenüberliegende Fläche dieses Backens unter einem geringen Winkel, beispielsweise unter einem Freiwinkel von 4 Grad verlaufen, so daß der Backen nicht einen größeren Bereich der Schutzfolie beaufschlagt als unbedingt nötig ist.

Damit der gegenüberliegende Backen seine Schälaufgabe gut bewältigen kann, verläuft seine der Laufebene gegen-überliegende Oberfläche zweckmäßigerweise in einem kleinen Winkel schräg zur Laufebene, beispielsweise unter einem Schneidwinkel von 4 Grad.

Einer der beiden Klemmbacken ist im Bereich des Klemmspaltes vorzugsweise mit einer Hinterschneidung versehen, in welche beim Zusammenpressen der Klemmbacken das Material der Fotoresistschicht hineinfließen kann.

Zum Abziehen der Schutzfolie wird das Klemmbackenpaar nun angehoben, wobei es eine Bahn beschreibt, die eine Komponente in Richtung auf die gegenüberliegende der Schutzfolie hat; die Richtung dieser Bewegungskomponente parallel zur Laufebene der Leiterplatten wird hier als die Abziehrichtung bezeichnet. Zweckmäßigerweise verläuft die Abziehrichtung schräg zur Förderrichtung des Förderers für die Leiterplatten, wobei die Leiterplatten während des Abziehvorganges festgehalten werden. Man könnte aber auch das Abziehen in einer Richtung senkrecht zur Förderrichtung der Leiterplatten vornehmen und das Abziehen bei in Förderrichtung bewegter Leiterplatte durchführen, wodurch ebenfalls ein Abziehen über Eck der Leiterplatten erfolgt, doch hat die letzt genannte Möglichkeit einen aufwendigeren Aufbau der Vorrichtung zur Folge.

Grundsätzlich könnte man den gesamten Abziehvorgang mit dem Klemmbackenpaar, welches den ersten Zipfel von der Leiterplatte löst durchführen. Vorzugsweise führt man mit dem Klemmbackenpaar jedoch nur den Beginn der Abziehbewegung durch und übergibt den abgezogenen Zipfel der Schutzfolie dann an einen weiteren Greifer, welcher zweckmäßigerweise in gleichbleibendem Abstand von der Laufebene der Leiterplatten gradlinig verfahrbar ist und den größten Teil der Abziehbewegung vollführt. Dieser Greifer kann ein verhältnismäßig einfacher, mechanisch betätigter Greifer sein, dessen Verfahrbarkeit längs eines geradelinigen Weges ohne Schwierigkeiten verwirklicht werden kann, wohin gegen das Verfahren des Klemmbackenpaares, welches einen komplizierten Bewegungsablauf hat und im Hinblick auf variierente Leiterplatten in mehrfacher Hinsicht justierbar sein muß, erheblich aufwendiger wäre, da man die Betätigungseinrichtungen und Justiereinrichtungen für das Klemmbackenpaar mit verfahren müsste, und zwar über Verfahrwege, die je nach Leiterplattengröße mehr als einen Meter betragen können.

Ein solcher Greifer, der die Schutzfolie vom Klemmbackenpaar übernimmt muss natürlich in eine Position (Übergabeposition) nahe bei den Klemmbacken verfahrbar sein; vorzugsweise hat der Greifer zwei gabelförmig angeordnete Fingerpaare, zwischen denen die Klemmbacken in ihrer Übergabeposition liegen, so daß die Finger den angehobenen Zipfel der Schutzfolie beidseits des Klemmbackenpaares ergreifen können. Hat der Greifer die Schutzfolie ergriffen, zieht er sie aus dem Spalt zwischen den beiden inzwischen drucklos gewordenen Klemmbacken heraus und schräg über die Leiterplatte hinweg von dieser ab.

Die Klemmvorrichtung für die Leiterplatten könnte ortsfest im Bereich des Klemmbackenpaares liegen; dann müsste man jedoch die Leiterplatten im unübersichtlichen Bereich der Klemmbacken positionieren, um sicherzustellen, daß diese tatsächlich einen Zipfel der Schutzfolie fassen können. Vorzugsweise ist aber die Klemmvorrichtung in Förderrichtung bewegbar und arretierbar. Die ermöglicht es, die Leiterplatten außerhalb des Bereiches der Klemmbacken, aber im Eingriffsbereich der verschiebbaren Klemmvorrichtung zu positionieren, dann in der Klemmvorrichtung zu Klemmen und sie anschließend mittels der Klemmvorrichtung über einen vorbestimmten, stets gleichbleibenden Weg zu verfahren, der die jeweilige Leiterplatte zwangsläufig in die richtige Endposition im Einwirkungsbereich des Klemmbackenpaares zu bringen, wo die Klemmvorrichtung dann arretiert wird und während des Abziehvorganges arretiert bleibt. Vorzugsweise greift die Klemmvorrichtung nahe der Ecke der Leiterplatte an, wo der Abziehvorgang beginnen soll, insbesondere an dem zur Förderrichtung parallelen Längsrand der Leiterplatte, weil dann die Abziehbewegung in erwünschter Weise in Richtung von der Einspannstelle der Leiterplatten fort erfolgt.

Grundsätzlich ist die Erfindung anwandbar auf liegend oder stehend oder in geneigter Lage geförderte Leiterplatten. Vorzugsweise verwendet die Vorrichtung einen Waagerechtförderer, auf welchem die Leiterplatten liegend gefördert werden, vorzugsweise auf einem Feld von zumindest teilweise angetriebenen Rollen oder Walzen mit gemeinsamer oberer Tangentialebene, welche die Laufebene der Leiterplatten definiert. Der Greifer, welcher die Schutzfolie abzieht, führt man schräg zur Förderrichtung über die Laufebene hinweg, vorzugsweise bis in einen Bereich außerhalb des Waagerechtförderers, was den Vorteil hat, daß man die am Greifer hängende, abgezogene Schutzfolie außerhalb des Waagerechtförderers durch Öffnen des Greifers auf bequemste Weise in einen Sammelbehälter fallen lassen kann.

In vielen Fällen haben die Leiterplatten auf beiden Seiten eine durch eine Schutzfolie abgedeckte Fotoresistschicht, so daß sich häufig die Aufgabe stellt, auf beiden Seiten der Leiterplatte eine Schutzfolie abziehen zu müssen. Überraschenderweise hat es sich ge zeigt, daß man von einer Leiterplatte, welche auf einem Rollenfeld oder einem Walzenfeld aufliegt, die Schutzfolie von der Unterseite dennoch abziehen kann, wenn man in dem Rollen- bzw. Walzenfeld eine sich in Abziehrichtung erstreckende Lücke vorsieht, in welcher der Greifer, der die untere Schutzfolie abziehen soll, möglichst dicht an der Laufläche der Leiterplatten entlang verfahren werden kann. Vorzugsweise hebt man dazu die jeweilige Leiterplatte mittels der ohnehin vorgesehenen Klemmvorrichtung ein wenig an - dazu genügen zwei Millimeter vollauf - um den Beginn des Abziehvorganges zu erleichtern. Hat der Greifer den zunächst abgelösten Zipfel der Schutzfolie erst einmal umgeschlagen und zwischen der Leiterplattenunterseite und dem Rollen- bzw. Walzenfeld eingefädelt, kann er auch bei aufliegender Leiterplatte den Abziehvorgang zum Abschluß führen.

Für das Abziehen von Schutzfolien von beiden Seiten einer Leiterplatte stattet man die Vorrichtung mit zwei Paaren von Klemmbacken und zwei Greifern aus, welche von ihnen die Schutzfolie übernehmen, wobei man jeweils einen Greifer und ein Klemmbackenpaar oberhalb und einen Greifer und ein Klemmbackenpaar unterhalb der Laufebene der Leiterplatten anordnet. Mit einer solchen Vorrichtung können die beiden Schutzfolien sychron abgelöst und abgezogen werden.

Wie bereits erwähnt, soll das Ablösen der Schutzfolien auf jedenfall mit einem Klemmbackenpaar erfolgen, welches sich, nachdem es einen Zipfel der Folie erfaßt hat, von der Leiterplatte entfernt und dabei bereits eine Bewegungskomponente in Abziehrichtung hat. Zweckmäßigerweise verschwenkt man zu diesem Zweck das Klemmbackenpaar durch parallele Lenker, welche um quer zur Abziehrichtung verlaufende Schwenkachsen verschwenkbar sind und eine Parallelführung des Klemmbackenpaares bewirken. Die Parallelführung hat den Vorteil, daß auch bei wechselnden Dicken der Leiterplatte die Klemmbacken stets in der selben Orientierung auf die Leiterplattenoberfläche auftreffen und außerdem wird die ergriffene Schutzfolie an der Klemmstelle zu stark umgebogen, was wichtig ist, damit sie nicht reißt. Die Kante des Klemmbackens, um welche sich die Schutzfolie dabei herumlegt, sollte nicht scharfkantig, sondern gerundet sein, damit sie die Schutzfolie nicht kerbt. Der Radius der Rundung kann sehr klein sein; in der Praxis genügt es, die Kante abzuziehen.

Die beigefügten Zeichnungen zeigen schematisch ein Ausführungsbeispiel der Erfindung.

**Fig. 1**
zeigt einen Ausschnitt aus der Draufsicht auf eine Vorrichtung zum Abziehen von Schutzfolien von Leiterplatten,

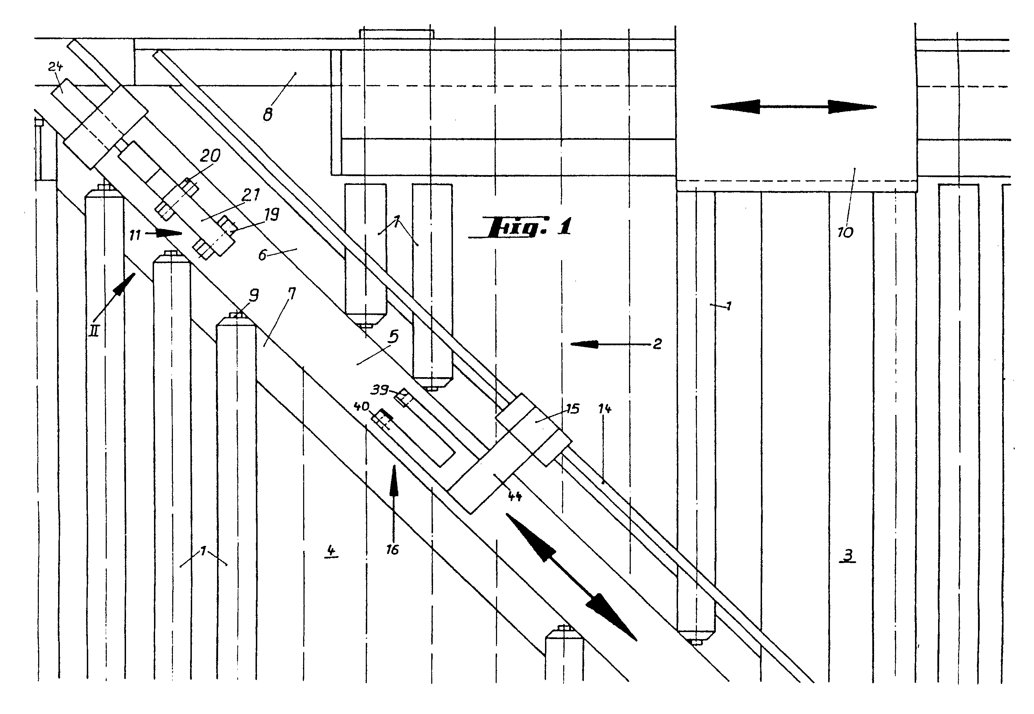

**Fig. 2**
zeigt als Detail die Ansicht in Richtung des Pfeils II in Fig.1 auf die Klemmbackenpaare der Vorrichtung, mit welchen die Schutzfolien an der Ecke abgelöst werden,

**Fig. 3 bis 6**
zeigen in vier aufeinander folgenden Phasen den Vorgang des Ablösens der Ecke einer Schutzfolie,

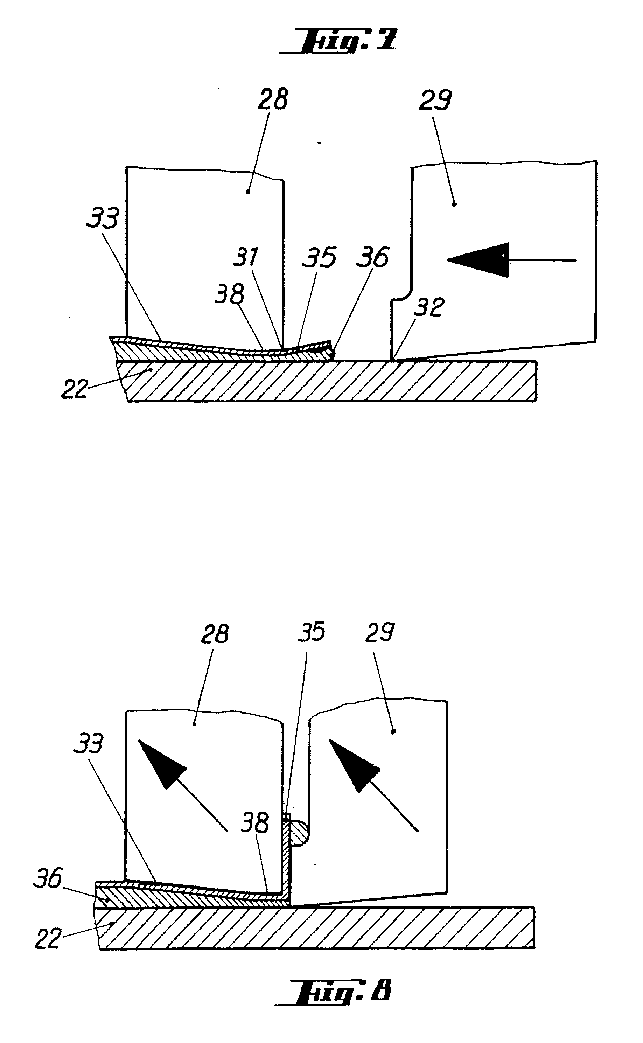

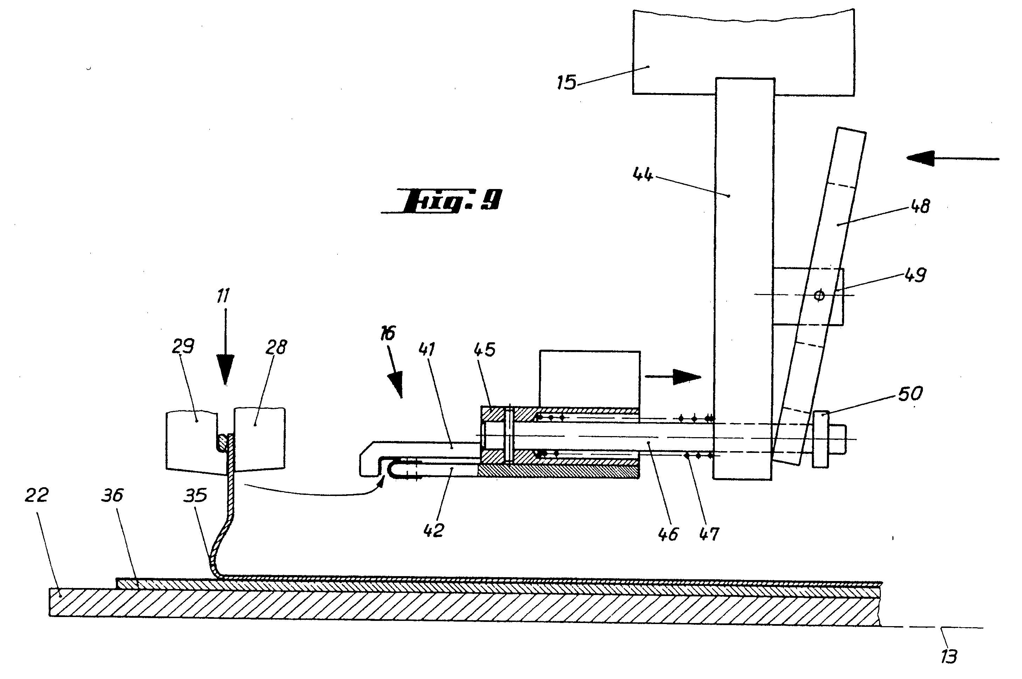

**Fig. 7 und 8**
sind Darstellungen entsprechend den Fig. 4 und 5, jedoch mit einem etwas abgewandelten Klemmbackenpaar,

**Fig. 9 und 10**
illustrieren den Vorgang der Übergabe der an einer Ecke abgelösten Schutzfolie von einem Klemmbachenpaar an den zugehörigen Greifer, und

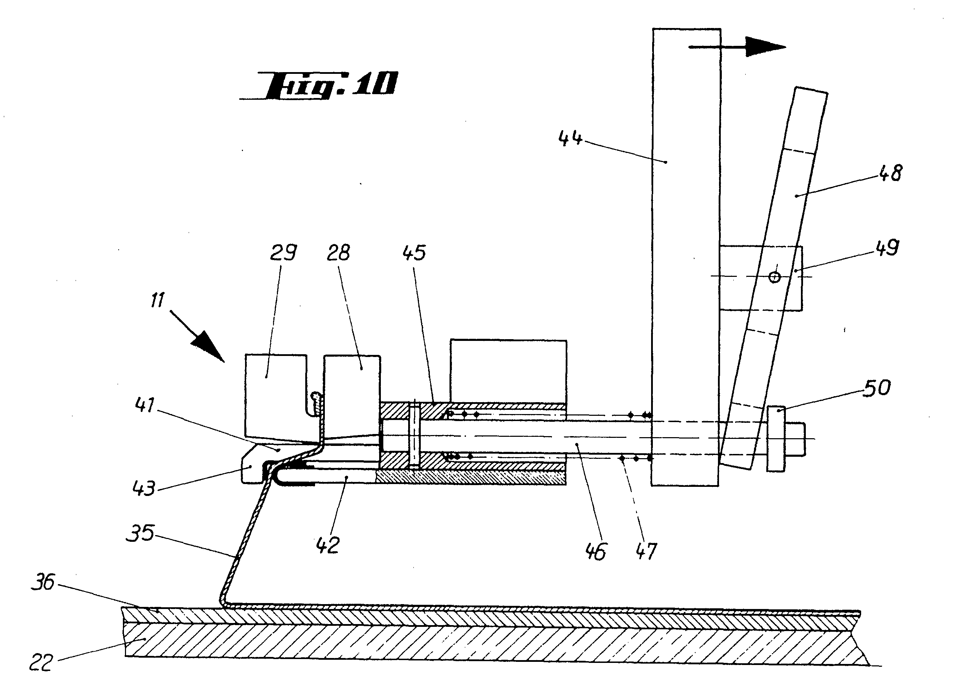

**Fig. 11 und 12**
zeigen die in den Fig. 9 und 10 dargestellten Elemente in der Draufsicht.

Fig. 1 zeigt in der Draufsicht einen Ausschnitt aus einem Waagerechtförderer, welcher aus einem Feld aus synchron angetriebenen Walzen 1 mit waagerechter Drehachse gebildet ist. Die Förderrichtung der Walzen ist durch den Pfeil 2 gekennzeichnet. Das Walzenfeld ist in einer Richtung schräg zur Förderrichtung 2 (im gezeichneten Beispiel unter einem Winkel von 45°) in zwei Abschnitte 3 und 4 getrennt. Die Lücke 5 zwischen den beiden Abschnitten 3 und 4 ist begrenzt durch zwei waagerechte, zueinander parallele entsprechend schräg zur Förderrichtung 2 verlaufende Träger 6 und 7, welche an seitlichen Rahmenteilen 8 der Vorrichtung befestigt sind und über hochstehende Laschen 9 die über den Träger 6 und 7 liegenden Enden der Walzen abstützen, deren äußere Enden über den seitlichen Rahmenteilen 8 abgestützt sind.

An dem in Förderrichtung 2 gesehen rechten seitlichen Rahmenteil 8 ist eine Klemmvorrichtung 10 in Förderrichtung und entgegen der Förderrichtung 2 verfahrbar angeordnet, mit deren Hilfe eine Leiterplatte an ihrem dort liegenden, zur Förderrichtung 2 parallelen Rand geklemmt und in den Einwirkungsbereich von zwei Klemmbackenpaaren gebracht und dort arretiert werden kann, die im Bereich der Lücke 5 oberhalb und unterhalb der Laufebene 13 der Leiterplatten angeordnet sind. Die Laufebene wird definiert durch die gemeinsame Tangentialebele der Walzen 1.

Oberhalb der Walzen 1 ist parallel zu dem Träger 6 eine Führungsschiene 14 vorgesehen, auf welcher ein Schlitten 15 hin und her verschiebbar ist. Der Schlitten trägt zwei Greifer 16, von denen einer oberhalb und einer unterhalb der Laufebene 13 angeordnet ist.

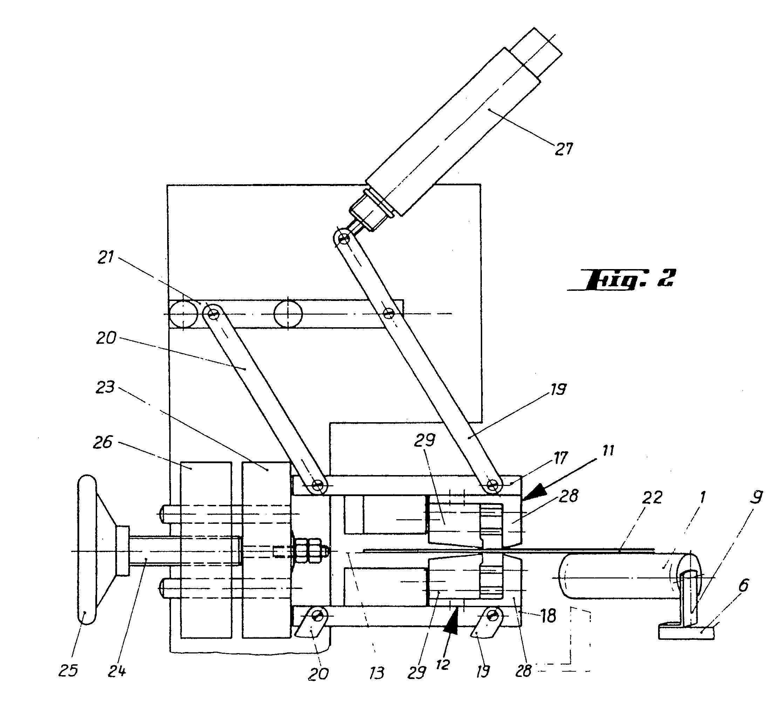

Die Fig. 2 zeigt im Detail die Anordnung der Klemmbackenpaare 11 und 12 oberhalb und unterhalb der Laufebene 13. Jedes Klemmbackenpaar ist auf einer Platte 17 bzw. 18 montiert, welche durch parallele Lenker 19 und 20 die an einem Rahmenteil 21 angelenkt sind, gegen die Laufebene 13 und von dieser fort schwenkbar, wobei die Lenker 19 und 20 für eine Parallelführung sorgen, so daß die Platten 17 und 18 ihre Ausrichtung parallel zur Laufebene 13 beibehalten. Die in Fig. 2 dargestellte Endlage der Platten 17 und 18, in welcher die Klemmbackenpaare die jeweilige Leiterplatte 22 berühren sollen, ist durch einen Anschlagblock 23 definiert, dessen Lage mittels einer Spindel 24 justierbar ist, die durch ein Handrad 25 verstellbar ist. Die Spindel selbst ist in einer gestellfesten Spindelbox 26 geführt.

Das Verschwenken der Platten 17 und 18 erfolgt mittels einer pneumatischen Kolben-Zylinder-Einheit 27, welche an einem der beiden Lenker 19 angreift, welcher als zweiarmiger Hebel ausgebildet ist.

Von den beiden Klemmbacken 28 und 29 eines jeden Klemmbackenpaares ist einer, nämlich der Backen 28 unverschieblich an der betreffenden Platte 17 und 18 angebracht, während der andere Backen 29 zum Schließen des Klemmbackenpaares horizontal verschieblich angeordnet ist.

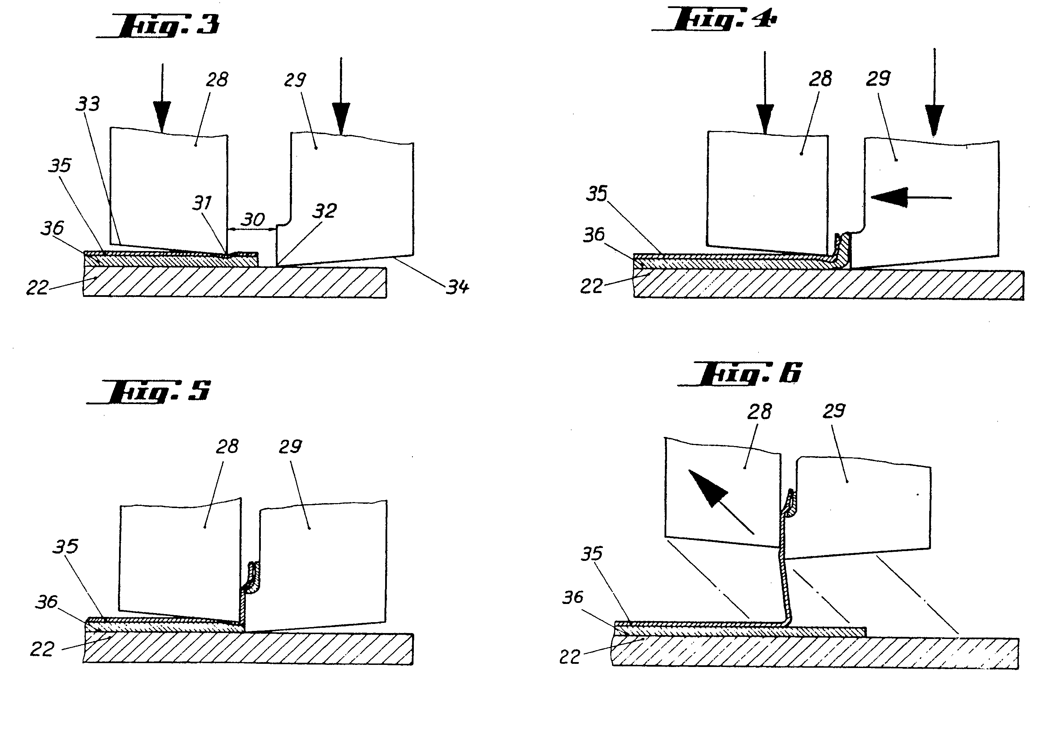

Wie man am Besten anhand der Fig. 3 bis 6 sieht, wird der Klemmspalt 30 zwischen den Backen 28 und 29 einerseits begrenzt durch eine untere waagerechte Kante 31 des festen Backens 28 und andererseits durch eine dazu parallele waagerechte unter Kante 32 des beweglichen Blocks 29. Die der Leiterplatte 22 zugewandten Oberflächen 33 bzw. 34 der beiden Backen verlaufen in einem spitzen Winkel schräg zur Leiterplattenoberfläche und damit schräg zur Laufebene 13. Die Kante 31 des festen Backens 28 dient zum Aufsetzen auf die Schutzfolie 35 nahe bei einer Ecke derselben. Die Kante 32 des beweglichen Backens 29 dient zum Aufsetzen auf die Leiterplatte 22, und zwar außerhalb der Schutzfolie 35, doch in der Nähe ihrer Ecke, an welcher der Abziehvorgang beginnen soll. Die Kante 32 des beweglichen Backens hat einen etwas geringeren Abstand von der Laufebene 13 als die ihr gegenüberliegende Kante 32 des festen Backens; daß hat zur Folge, daß beim Aufsetzen der beiden Backen 28 und 29 auf die Leiterplatte 22 zwar die unter der Schutzfolie 35 liegende Fotoresistschicht 36 gequetscht wird, jedoch ohne die kerbempfindliche Schutzfolie 35 zu beschädigen (Fig. 3). Zum Ablösen der Schutzfolie 35 wird nun der bewegliche Backen 29 gegen den festen Backen 28 geschoben, wobei er den vor dem festen Backen 28 liegenden Zipfel der Schutzfolie 35 mitsamt der darunterliegenden Fotoresistschicht 36 abschält (Fig. 4) und schließlich festklemmt (Fig. 5) wobei das abgequetschte und abgeschälte Material der Fotoresistschicht in einen Freiraum 37 zwischen den Backen 28 und 29 verdrängt wird, welcher durch eine Hinterschneidung im beweglichen Backen 29 gebildet ist (Fig. 5) nun wird durch Verschwenken der Platten 17 auf der Oberseite bzw. 18 an der Unterseite der Leiterplatte 22 das Klemmbackenpaar von der Leiterplatte abgehoben und dadurch die Schutzfolie 35 ein stückweit abgezogen, nicht jedoch die darunterliegende Fotoresistschicht 36, denn diese reißt an der Stelle, wo sie durch den festen Backen 28 gequetscht wurde,ab.

Die Fig. 7 und 8 zeigen das Abschälen der Schutzfolie und Fotoresistschicht und ihr Einklemmen an einem etwas abgewandelten Klemmbackenpaar. Die Abwandlung besteht darin, daß der feste Klemmbacken 28 in der Nachbarschaft seiner unteren Kante 31 zunächst einen schmalen Oberflächenstreifen 38 hat, der parallel zur Laufebene 13 ist, und erst anschließend an diesen schmalen Streifen 38 ist ein schräg verlaufender Oberflächenbereich 33 ausgebildet.

Die Kanten 31 und 32 der beiden Backen sind nicht scharfkantig ausgeführt, sondern gerundet (abgezogen), um ein Reißen der Schutzfolie beim Abziehen zu vermeiden.

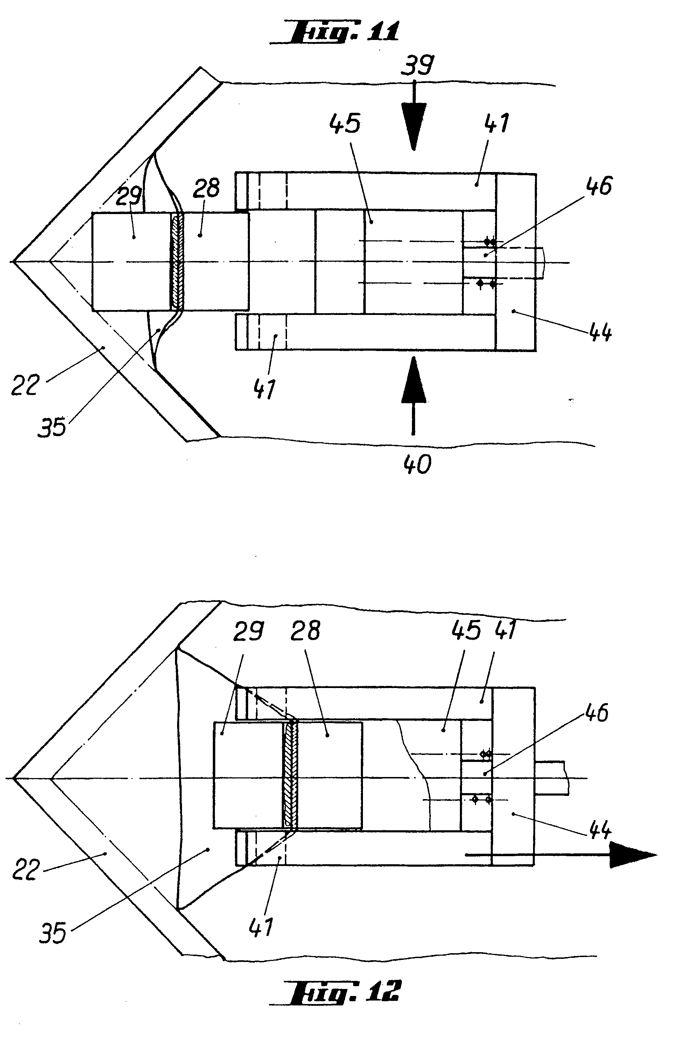

Das Abziehen der Schutzfolie 35 längs der Führungsschiene 14 wird nicht von den Klemmbackenpaaren 11 und 12 zu Ende geführt, sondern durch die gesonderten Greifer 16, von denen in den Zeichnungen nur der Greifer oberhalb der Laufebene 13 dargestellt ist; der unterhalb der Laufebene 13 angeordnete Greifer ist im wesentlichen gleich ausgebildet und spiegelbidlich zu diesem angeordnet. Wie die Übergabe des abgelösten Zipfels der Schutzfolie 35 vom Klemmbackenpaar 11 an den Greifer 16 erfolgt, zeigen die Fig. 9 bis 12. Der Greifer 16 besteht aus zwei gabelför-mig angeordneten, waagerecht verlaufenden Fin-gerpaaren 39 und 40, jeweils bestehend aus einem oberen, an seiner Spitze mit einem nach unten gebogenen Haken 43 versehenen Finger 41, welcher an einem Träger 44 befestigt ist, welcher seinerseits fest mit dem Schlitten verbunden ist, sowie ferner aus einem geradlinigen Finger 42, welcher unter dem Finger 41 angeordnet ist und mit seiner Spitze gegen den Haken 43 des oberen Fingers gerichtet ist. Dieser untere Finger 42 ist an der Unterseite eines Blocks 45 befestigt, welcher auf einem Rundstab 46 befestigt ist, der längsverschieblich durch den Träger 44 hindurch geführt ist. Zwischen dem Block 45 und dem Träger 44 ist eine Druckfeder 47 vorgesehen, welche den unteren Finger 42 gegen den Haken 43 des oberen Fingers drückt.

Zum Übernehmen des Zipfels der Schutzfolie 35, welche von den Backen 28 und 29 von der Fotoresistschicht 36 der Leiterplatte 22 abgelöst wurde, wird der Greifer 16 in eine Endposition in der Nähe des Klemmbackenpaares 11 verfahren (Fig.9). Das hochschwenkende Klemmbackenpaar 11 fährt zwischen die beiden Fingerpaare 39 und 40 des Greifers 16 (Fig. 11 und 12) und fädelt den Zipfel der Schutzfolie 35 in den sich öffnenden Spalt zwischen den Finger 41 und 42 ein. Das Öffnen des Greifers 16 kann dadurch erfolgen, daß der Greifer mit seinem Block 45 kurz vor erreichen seiner Endposition gegen einen ortsfesten Anschlag fährt, wodurch die beiden Finger 39 und 40 gegeneinander verschoben werden, oder dadurch, daß der Backen 28 gegen den Block 45 fährt und den Finger 42 verschiebt.

Das Klemmbackenpaar 11 wird dann drucklos gemacht, aber nicht geöffnet, so daß der Zipfel der Schutzfolie 35 noch zwischen ihnen stecken bleibt, gleichwohl aber herausgezogen werden kann. Nun wird der Schlitten 15 zurück bewegt, wodurch sich automatisch der Greifer 16 schließt, die Schutzfolie 35 zwischen sich einklemmt, zwischen den Backen 28 und 29 herauszieht, mit sich mitführt und so die Schutzfolie insgesamt von der Leiterplatte 22 abzieht (Fig. 10 und 12).

An der Rückseite des Trägers 44 ist eine Wippe 48 angebracht, welche um eine waagerechte Achse 49 verschwenkbar ist und deren unteres Ende vom Rundstab 46 durchsetzt wird, der an seinem Ende mit einem Gewinde versehen ist und eine Mutter 50 trägt, welche verhindert, daß das untere Ende der Wippe 48 zum Rundstab herunter gleitet.

Kurz vor Erreichen der Endstellung des Schlittens 15 außerhalb des Bereiches des Feldes aus den Walzen 1 läuft das obere Ende der Wippe auf einen Endanschlag auf, wodurch die Wippe 48 verschwenkt, dadurch der Greifer 16 geöffnet und die Schutzfolie 35 frei heraus fallen kann in einen darunter aufgestellten Sammelbehälter. Anschließend kehrt der Greifer 16 in seine Übergabeposition (Fig.9) zurück und ist bereit, erneut eine Schutzfolie 35 zu übernehmen und abzuziehen.

## Ansprüche

1. Vorrichtung zum Abziehen der Schutzfolie von einer mit belichtetem Fotoresist beschichteten Leiterplatte (22) und einem dieselbe in den Bereich einer Abziehvorrichtung transportieren-den Förderer, welcher die Laufebene der Leiterplatte (22) definiert, wenigstens einem Klemmbackenpaar, welches in Abziehrichtung beweg- und schließbar ist, wobei die beiden Backen (28,29) je eine quer zur Abziehrichtung parallel zur Laufebene verlaufende, den Klemmspalt zwischen den Backen (28,29) begrenzenden Kante (31,32) zum Anlegen an die jeweilige Leiterplatte haben,
**gekennzeichnet durch** eine Klemmvorrichtung zum Fixieren der Leiterplatte (22) an ihrem Rand in vorbestimmter Lage, wobei dem Klemmplattenpaar (11,12) bestehend aus einer Quetsch- (28) und einer Schälbacke (29) für diagonale Klemm-Abziehrichtung, beginnend an einer Ecke der Schutzfolie und endend an der ihr diagonal gegenüberliegenden Ecke ein in dieser Richtung bewegbarer Greifer (16) zugeordnet ist, welcher zum Übernehmen des zwischen den Klemmbacken (28,29) befindlichen Zipfels der Schutzfolie (35) in eine Position (Übergabeposition) neben die von der Laufebene (13) entfernten Klemmbacken (28,29) verfahrbar ist.

2. Vorrichtung nach Anspruch 1,
dadurch gekennzeichnet, daß die Kanten den Backen (31,32) mit geringem Radius gerundet sind.

3. Vorrichtung nach Anspruch 1 oder 2,
dadurch gekennzeichnet, daß die Kante (32) des schliessenden Backens (29) geringfügig, nämlich ungefähr um die Dicke der Schutzfolie (35), näher bei der Laufebene der Leiterplatten (22) liegt als die Kante (31) des anderen Bakkens (28).

4. Vorrichtung nach einem der vorstehenden Ansprüche,
dadurch gekennzeichnet, daß die Schließbewegung des einen Backens (29) parallel zur Laufebene (13) der Leiterplatten (22) erfolgt.

**5.** Vorrichtung nach einem der vorstehenden Ansprüche,
dadurch gekennzeichnet, daß die Kante (32) des schliessenden Backens (29) als Schälkante ausgebildet und die daran angrenzende, der Laufebene (13) zugewandte Oberfläche (34) des Backens (29) zu diesem Zweck unter einem geringen Winkel schräg zur Laufebene (13) verläuft.

**6.** Vorrichtung nach einem der vorstehenden Ansprüche,
dadurch gekennzeichnet, daß die der Laufebene (13) zugewandte Oberfläche (33) des beim Schließen ruhenden Backens (28) in einem an seine Kante (31) angrenzenden schmalen Bereich (38) zur Laufebene (13) parallel ist und im übrigen unter einem Winkel (Freiwinkel) schräg zur Laufebene (13) verläuft.

**7.** Vorrichtung nach einem der vorstehenden Ansprüche,
dadurch gekennzeichnet, daß das Klemmbakkenpaar (11,12) durch parallele Lenker (19,20) mit zur Laufebene (13) parallelen, quer zur Abziehvorrichtung verlaufenden Schwenkachsen parallel geführt verschwenkbar ist.

**8.** Vorrichtung nach Anspruch 1,
dadurch gekennzeichnet, daß wenigstens einer der Backen (29) im Bereich des Klemmspaltes eine Hinterschneidung (37) aufweist.

**9.** Vorrichtung nach Anspruch 1,
dadurch gekennzeichnet, daß der Greifer (16) zwei gabelförmig angeordnete Fingerpaare (39,40) hat, zwischen denen die Klemmbacken (28,29) in ihrer Übergabeposition liegen.

**10.** Vorrichtung nach Anspruch 1,
dadurch gekennzeichnet, daß die Klemmvorrichtung (10) in Förderrichtung bewegbar und arretierbar ist.

**11.** Vorrichtung nach Anspruch 1 oder 10,
dadurch gekennzeichnet, daß die Klemmvorrichtung (10) so angeordnet ist, daß sie die Leiterplatten (22) nahe bei den Klemmbacken (11,12) an dem zur Förderrichtung parallelen Rand der Leiterplatten (22) fixieren.

**12.** Vorrichtung nach Anspruch 1,
dadurch gekennzeichnet, daß der Förderer ein Waagerechtförderer ist, auf welchem die Leiterplatten (22) auf einem aus Pollen oder Walzen (1) mit waagerechter Achse und mit gemeinsamer Tangentialebene gebildeten Feld liegend transportiert werden.

**13.** Vorrichtung nach Anspruch 1 oder 9 und 10,
dadurch gekennzeichnet, daß ein Klemmbakkenpaar (11) mit zugeordnetem Greifer (16) oberhalb und ein weiteres Klemmbackenpaar (12) mit zugeordnetem Greifer unterhalb der Laufebene (13) angeordnet ist und in dem durch die Rollen oder Walzen (1) gebildeten Feld eine in Abziehrichtung verlaufende durchgehende Lücke (5) vorgesehen ist, in welcher die Bewegungsbahn des unteren Greifers verläuft.

**14.** Vorrichtung nach Anspruch 1 und 12,
dadurch gekennzeichnet, daß die Klemmvorrichtung (10) die Leiterplatten (22) in geringem Abstand oberhalb des Feldes aus Rollen oder Walzen (1) fixiert.

**15.** Vorrichtung nach Anspruch 1 und 12 oder 13,
dadurch gekennzeichnet, daß sich die Bewegungsbahn des bzw. der Greifer (16) bis über die seitliche Begrenzung des Feldes aus Rollen oder Walzen (1) hinaus erstreckt.

**Claims**

**1.** Device for peeling off the protective film from a printed circuit board (22) coated with exposed photoresist and from a conveyor transporting same to the area of a peeling-off device, said conveyor defining the running plane of the printed circuit board (22), from at least one pair of clamping jaws movable and closable in peeling direction, the two jaws (28, 29) having an edge (31, 32) to be aligned with the respective printed circuit board, said edge extending transversely to the peeling direction and parallel to the running plane and defining the clamping gap between the jaws (28, 29), characterized in that it comprises a clamping device for fixing the printed circuit board (22) at its edge in a predetermined position, the pair of clamping plates (11, 12) consisting of a squeezing jaw (28) and a peeling jaw (29) for a diagonal clamping/peeling direction starting at one corner of the protective film and ending at the corner diagonally opposite to the first corner, having a gripper (16) movable in this direction associated thereto, said gripper being shiftable to a position (transfer position) next to the clamping jaws (28, 29) remote from the running plane (13) for taking over the end of the protective film (35) which is held between the clamping jaws (28, 29).

**2.** Device according to Claim 1, characterized in that the edges of the jaws (31, 32) are rounded with a small radius.

3. Device according to Claim 1 or 2, characterized in that the edge (32) of the closing jaw (29) is slightly, i.e. by approximately the thickness of the protective film (35), closer to the running plane of the printed circuit boards (22) than the edge (31) of the other jaw (28).

4. Device according to one of the preceding claims, characterized in that the closing movement of the one jaw (29) is carried out parallel to the running plane (13) of the printed circuit boards (22).

5. Device according to one of the preceding claims, characterized in that the edge (32) of the closing jaw (29) is formed as a peeling edge and for this purpose the surface (34) of the jaw (29), which faces the running plane (13), extends at a slight angle relative to the running plane (13).

6. Device according to one of the preceding claims, characterized in that the surface (33) facing the running plane (13), of the jaw (28) which is not moving during the closing operation, is parallel to the running plane (13) in a small area (38) adjacent to the edge (31) thereof and otherwise extends at an angle (clearance angle) relative to the running plane (13).

7. Device according to one of the preceding claims, characterized in that the pair of clamping jaws (11, 12) is pivotable by parallel control mechanisms (19, 20) guided in parallel by pivoting axes extending parallel to the running plane (13) and transversely to the peeling device.

8. Device according to Claim 1, characterized in that at least one of the jaws (28) has a back-cut (37) in the area of the clamping gap.

9. Device according to Claim 1, characterized in that the gripper (16) has two pairs of forked fingers (39, 40), between which the clamping jaws lie in their transfer positions.

10. Device according to claim 1, characterized in that the clamping device (10) is movable and lockable in the transport direction.l

11. Device according to Claim 1 or 10, characterized in that the clamping device (10) is arranged such that it fixes the printed circuit boards (22) near the clamping jaws (11, 12) at the edge of the printed circuit boards (22), which is parallel to the transport direction.

12. Device according to claim 1, characterized in that the conveyor is a horizontal conveyor, on which the printed circuit boards (22) are transported lying on a surface formed by rollers or drums (1) having a horizontal axis and a common tangential plane.

13. Device according to Claim 1 or 9 or 10, characterized in that a pair of clamping jaws (11) with associated gripper (16) is arranged above and another pair of clamping jaws (12) with associated gripper is arranged below the running plane (13) and that on the surface formed by the rollers or drums (1) a through-gap extending in peeling direction is provided, wherein the moving path of the bottom gripper extends.

14. Device according to Claims 1 and 12, characterized in that the clamping device (10) fixes the printed circuit boards (22) at a small distance above the field formed by rollers or drums (1).

15. Device according to Claims 1 and 12 or 13, characterized in that the moving path of the gripper(s) (16) extends beyond the lateral boundary of the field formed by rollers or drums (1).

**Revendications**

1. Dispositif pour enlever la feuille de protection d'une plaquette imprimée (22) recouverte d'une couche photorésistante exposée et d'un convoyeur transportant celle-ci dans la zone d'un dispositif d'enlèvement, lequel convoyeur définit le plan de défilement de la plaquette imprimée (22), au moins une paire de mâchoires de serrage, laquelle peut se déplacer et se fermer dans la direction d'enlèvement, les deux mâchoires (28,29) ayant chacune une arête (31,32) s'étendant transversalement à la direction d'enlèvement parallèlement au plan de défilement, délimitant la fente de serrage entre les mâchoires (28,29), pour s'appuyer contre la plaquette imprimée concernée, caractérisé par un dispositif de serrage pour fixer la plaquette imprimée (22) par son bord dans une position prédéterminée, à la paire de plaques de serrage (11,12) composée d'une mâchoire de serrage (28) et d'une mâchoire de pelage (29), pour un serrage et un enlèvement dans une direction diagonale, débutant en un coin de la feuille de protection et se terminant au coin diagonalement opposé, est ajoutée une griffe (16) mobile dans cette direction, laquelle est déplaçable pour recevoir le bout de la feuille de protection (35) situé entre les mâchoires de serrage (28,29) dans une position (position de transfert) à côté des mâchoires de serrage une fois éloignées du plan de défilement (13).

2. Dispositif selon la revendication 1, caractérisé en ce que les arêtes (31,32) des mâchoires sont arrondies avec un faible rayon.

3. Dispositif selon la revendication 1 ou 2, caractérisé en ce que l'arête (32) de la mâchoire (29) se fermant est située légèrement, c'est-à-dire environ de l'épaisseur de la feuille de protection (35), plus près du plan de défilement de la plaquette imprimée (22) que l'arête (31) de l'autre mâchoire (28).

4. Dispositif selon l'une des revendications précédentes, caractérisé en ce que le mouvement de fermeture de l'une des mâchoires (29) s'effectue parallèlement au plan de défilement (13) de la plaquette imprimée (22).

5. Dispositif selon l'une des revendications précédentes, caractérisé en ce que l'arête (32) de la mâchoire se fermant (29) est conformée en tant qu'arête de pelage et que la surface (34) de la mâchoire (29), tournée vers le plan de défilement (13), adjacente à l'arête, s'étend dans ce but en étant inclinée d'un faible angle par rapport au plan de défilement (13).

6. Dispositif selon l'une des revendications précédentes, caractérisé en ce que la surface de la mâchoire (28) fixe lors de la fermeture tournée vers le plan de défilement, est parallèle au plan de défilement (13) dans une étroite zone (28) adjacente à son arête (31) et s'étend par ailleurs en étant inclinée d'un angle (angle libre) par rapport au plan de défilement (13).

7. Dispositif selon l'une des revendications précédentes, caractérisé en ce que la paire de mâchoires de serrage (11,12) est guidée pivotante parallèlement par deux guides parallèles (19,20) avec des axes de pivotement parallèles au plan de défilement (13) et s'étendant transversalement au dispositif d'enlèvement.

8. Dispositif selon la revendication 1, caractérisé en ce qu'au moins l'une des mâchoires (29) comporte une contre-dépouille (37) dans la zone de la fente de serrage.

9. Dispositif selon la revendication 1, caractérisé en ce que la griffe (16) a deux paires de doigts (39,40) agencées en forme de cuillère, entre lesquels sont situées les mâchoires de serrage (28,29) une fois dans leur position de transfert.

10. Dispositif selon la revendication 1, caractérisé en ce que le dispositif de serrage (10) peut être déplacé et arrêté dans la direction du convoyeur.

11. Dispositif selon la revendication 1 ou 10, caractérisé en ce que le dispositif de serrage (10) est agencé de façon à fixer les plaquettes imprimées (22) au voisinage des mâchoires de serrage (11,12) par le bord des plaquettes imprimées (22) parallèles à la direction de défilement.

12. Dispositif selon la revendication 1, caractérisé en ce que le convoyeur est un convoyeur horizontal, sur lequel les circuits imprimés (22) sont transportés en étant disposés à plat sur un faisceau de rouleaux ou cylindres (1) avec des axes horizontaux et un plan tangentiel commun.

13. Dispositif selon la revendication 1 ou 9 ou 10, caractérisé en ce qu'une paire de mâchoires de serrage (11) et la griffe associée (16) sont disposées au-dessus du plan de défilement (13), une autre paire de mâchoires de serrage (12) et la griffe associée, étant disposées en dessous du plan de défilement (13) et en ce qu'il est prévu dans le faisceau de rouleaux ou cylindres (1) un intervalle (5) traversant, s'étendant dans la direction d'enlèvement, dans lequel se situe la trajectoire du mouvement de la griffe inférieure.

14. Dispositif selon les revendications 1 et 12, caractérisé en ce que le dispositif de serrage (10) fixe les plaquettes imprimées (22) à faible distance au-dessus du faisceau de rouleaux ou cylindres (1).

15. Dispositif selon les revendications 1 et 12 et 13, caractérisé en ce que le trajet du mouvement de la ou des griffes (16) s'étend jusqu'au-delà de la limite latérale du faisceau de rouleaux ou tambours (1).

Fig. 1

Fig. 2

EP 0 214 461 B1

Fig. 3

Fig. 4

Fig. 5

Fig. 6

12

Fig. 7

Fig. 8

Fig. 9

EP 0 214 461 B1

Fig. 10

EP 0 214 461 B1

_Fig. 11_

_Fig. 12_